# EUROPÄISCHE PATENTSCHRIFT

(11) **EP 2 696 464 B1**
(45) Veröffentlichungstag und Bekanntmachung des Hinweises auf die Patenterteilung: **07.01.2015**
(21) Anmeldenummer: 12179571.0
(22) Anmeldetag: 07.08.2012
(51) Int. Cl.: H02J 3/38, H02J 3/24, F03D 9/00, H01L 31/042, H02M 7/00

(54) **Fotovoltaik-Kraftwerk**
Photovoltaic power plant
Centrale photovoltaïque

(43) Veröffentlichungstag der Anmeldung: 12.02.2014
(73) Patentinhaber: AEG Power Solutions GmbH, 59581 Warstein-Belecke (DE)
(72) Erfinder: Blacha, Norbert, 59581 Warstein (DE); Kempen, Stefan, 59821 Arnsberg (DE)
(74) Vertreter: Graefe, Jörg

(56) Entgegenhaltungen:
- DE-A1- 2 231 802
- DE-A1- 3 439 700
- DE-A1- 3 445 535
- DE-A1- 3 514 804
- DE-A1- 10 305 128
- DE-A1-102010 047 652
- DE-B- 1 149 100
- DE-U1-202008 007 846
- DE-U1-202010 016 873
- US-B1- 6 239 513
- US-B1- 7 847 423

## Beschreibung

Die vorliegende Erfindung betrifft ein Fotovoltaik-Kraftwerk
- mit Fotovoltaikmodulen zur Stromerzeugung, die zu mehreren Strängen zusammengeschaltet sind, wobei die Stränge parallel geschaltet sind,
- mit einem zentralen Umformer, nämlich einem Zentralwechselrichter, oder dezentralen Umformern, zur Wandlung von von den Fotovoltaikmodulen erzeugter elektrischer Energie in elektrische Energie mit einer Spannung, die eine Spannungsform hat, die einer Spannungsform einer Spannung in einem Versorgungsnetz entspricht, und
- mit einem Ausgang zur Einspeisung des gewandelten Stroms in das Versorgungsnetz.

Fotovoltaik-Kraftwerke sind heute in weiten Teilen der Welt alltäglich. Neben Fotovoltaik-Kraftwerken im Inselbetrieb, die in der Regel nur kleinere Leistungen haben, haben Fotovoltaik-Kraftwerke im netzgekoppelten Betrieb die weitaus größere Bedeutung. Anders als Fotovoltaik-Kraftwerke im Inselbetrieb speichern netzgekoppelte Anlagen die gewonnene elektrische Energie in der Regel nicht ein sondern speisen diese in ein Versorgungsnetz ein. Bei dem Netz in das eingespeist wird, kann es sich um ein Niederspannungsnetz, ein Mittelspannungsnetz oder ein Hochspannungsnetz handeln, wobei in Deutschland die Einspeisung derzeit in der Regel in der unteren oder der mittleren Netzebene, d.h. im Niederspannungsnetz oder im Mittelspannungsnetz erfolgt.

Ein solches Fotovoltaik-Kraftwerk ist in dem Dokument DE 20 2010 016 873 U1 beschrieben.

DE 103 05 128 beschreibt ein Verfahren zur Regelung eines Wärmemotors, der in einem Hybridantrieb eingebunden ist und mit Wärme betrieben wird. Als weiterer Antrieb ist ein Elektromotor vorgesehen, der von Solarzellen betrieben wird und sein Drehmoment auf die Generatorwelle eines Synchrongenerators einspeist.

Die Idee, einen mechanischen Wechselrichter, der aus einem Gleichstrommotor mit einem Synchrongenerator besteht, für eine Photovoltaikanlage einzusetzen, ist aus DE 10 2010 047 652 bekannt. Hier wird ein Verfahren zur Regelung der Blindleistung über den Wirkfaktor cos Phi beschrieben.

Die Idee der Verschaltung eines Asynchronmotors mit einem Synchrongenerator ist in DE 1 149 100 und in US 6,239,513 offenbart, jedoch nicht in Verbindung mit einem Fotovoltaik-Kraftwerk.

Hauptlieferant von elektrischer Energie sind in den meisten Industrieländern der Erde Dampfkraftwerke und Wasserkraftwerke. Dampfkraftwerke wandeln chemische Energie in Kohle, Gas oder Öl oder Kernenergie in elektrische Energie. Wasserkraftwerke erzeugen aus der kinetischen Energie von Wasser elektrische Energie. Durch den Dampf oder das Wasser werden in der Regel Synchrongeneratoren angetrieben, die an den Ausgängen des Kraftwerkes eine sinusförmige Spannung zur Verfügung stellen und diese dem Versorgungsnetz aufprägen. Die von den Synchrongeneratoren erzeugte Spannung ist fast frei von Oberschwingungen und Unterschwingungen.

Das ist bei Fotovoltaik-Kraftwerken, wie bei dem in dem Dokument DE 20 2010 016 873 U1 offenbarten, nicht ohne besonderen Aufwand zu erreichen, da die Fotovoltaikmodule eines Fotovoltaik-Kraftwerkes zunächst eine Gleichspannung liefern, die durch Wechselrichter, seien es Strangwechselrichter oder Zentralwechselrichter, in Wechselspannung gewandelt werden. Die Wandlung erfolgt durch leistungselektronische Bauelemente, die heute in großer Zahl und akzeptablem Preis verfügbar sind. Die vom Wechselrichter zur Verfügung gestellte Spannung ist jedoch prinzipiell nicht frei von Ober- oder Unterschwingungen. Deshalb wird heute ein erheblicher Aufwand getrieben, um Ober- und Unterschwingungen vor dem Einspeisen der erzeugten elektrischen Energie in das Versorgungsnetz herauszufiltern. Gerade für große Fotovoltaik-Kraftwerke ist der Aufwand sehr erheblich.

Bevor ein Fotovoltaik-Kraftwerk an ein Versorgungsnetz angeschlossen werden darf, muss dem Versorgungsnetzbetreiber nachgewiesen werden, dass die Anforderungen des Versorgungsnetzbetreibers an die Einspeisung von elektrischer Energie erfüllt sind. Dabei gilt der Grundsatz, dass der Aufwand für den Nachweis um so größer ist, je größer die Leistung des Kraftwerks ist.

Diesen Aufwand zu reduzieren ist das Ziel der Erfindung.

Der Erfindung liegt die Aufgabe zugrunde, ein Fotovoltaik-Kraftwerk so weiter zu entwickeln, dass eine Einspeisung von von Fotovoltaik-Kraftwerken erzeugter elektrischer Energie möglichst frei von Ober- und Unterschwingungen möglich ist.

Diese Aufgabe wird erfindungsgemäß durch ein Fotovoltaik-Kraftwerk mit den Merkmalen des Anspruchs 1 gelöst, der gegen die DE 20 2010 016 873 U1 abgegrenzt wurde. Demnach weist ein erfindungsgemäßes Fotovoltaikkraftwerk eine zweistufige Spannungsumformung auf. Zunächst wird der von den Fotovoltaikmodulen gelieferte Gleichstrom mit einem Zentralwechselrichter (zweiten zentralen Umformer) und dezentralen Umformern (z.B. Strangwechselrichter) in einen Strom umgeformt, der nicht den Anforderungen eines Netzbetreibers zur Einspeisung genügen muss. In einem zweiten Schritt wird der nicht den Anforderungen eines Netzbetreibers genügende Wechselstrom mit dem ersten zentralen Umformer in Wechselstrom umgeformt, der möglichst frei von Ober- und Unterschwingungen ist. Der erste zentrale Umformer des Fotovoltaik-Kraftwerkes weist wenigstens einen Elektromotor und einen Synchron-Generator auf, deren Wellen miteinander gekoppelt sind.

Die historische Entwicklung von Fotovoltaik-Kraftwerken beginnt bei Fotovoltaik-Pionieren, die in den achtziger und neunziger Jahren des vergangenen Jahrhunderts erste Fotovoltaik-Kleinkraftwerke mit geringerer Leistung ans Versorgungsnetz angeschlossen haben, um Energie in das Stromnetz einzuspeisen. Die von diesen Fotovoltaik-Pionieren zum Teil selbst gebauten Fotovoltaik-Kraftwerke besaßen Wechselrichter, die in ihrer Grundform auch noch heute Verwendung finden. Die verwendeten Leistungshalbleiterbauelemente und die daraus aufgebauten Wechselrichter wurden seit dieser Zeit stetig technisch verbessert. Die Leistung der Module und der Wechselrichter wurden vergrößert. Beides machte immer größere Fotovoltaik-Kraftwerke möglich, so dass heute Fotovoltaik-Kraftwerke mit Leistungen von mehreren Megawatt möglich sind.

Im Grunde genommen wurde in der Vergangenheit an der Topologie von Fotovoltaik-Kraftwerken wenig verändert. Vor der Einspeisung stand und steht immer die Wandlung des Gleichstroms in einen Wechselstrom durch einen Wechselrichter mit Leistungshalbleitern. Dass andere Entwicklungen verfolgt wurden, ist nicht bekannt.

Dabei bietet die erfindungsgemäße Wandlung des Gleichstroms in Wechselstrom mit Hilfe eines Elektromotors und eines Synchrongenerators, die als solche seit langem bekannt ist, eine Reihe von Vorteilen.

Zunächst einmal ist eine Anbindung des Fotovoltaik-Kraftwerkes an ein Versorgungsnetz möglich, ohne dass die Gefahr besteht, dass aus dem Fotovoltaik-Kraftwerk Ober- oder Unterschwingungen in das Versorgungsnetz übertragen werden.

Darüber hinaus bietet die Wandlung der elektrischen Energie und die Bereitstellung einer Spannung konform mit dem Versorgungsnetz andere Vorteile:
Sowohl der Elektromotor als auch der Synchrongenerator haben aufgrund der Läufer eine rotierende Masse. Diese rotierende Masse speichert kinetische Energie, die Leistungsschwankungen der Fotovoltaikmodule aufgrund sich kurzfristig ändernder Sonneneinstrahlung, zum Beispiel durch eine Wolke, dadurch abmildern kann, dass im Fall eines plötzlichen Leistungsrückgangs kinetische Energie der Läufer und Wellen in elektrische Energie gewandelt wird.

Synchrongeneratoren sind oft seit Jahrzehnten im Einsatz um netzkonforme elektrische Energie zu erzeugen. Die Netzbetreiber kennen die Technologie und mögliche Auswirkungen eines Synchrongenerators auf ein Versorgungsnetz. Die Zulassung der Netzanbindung eines erfindungsgemäßen Fotovoltaik-Kraftwerkes wird daher kaum auf Bedenken eines Versorgungsnetzbetreibers stoßen. Es wird erwartet, dass Versorgungsnetzbetreiber Fotovoltaik-Kraftwerke sogar bevorzugt an ein Netz anschließen, da eine netzseitige Kompensation von Störungen nicht notwendig sein wird und im Gegenteil die Qualität der verfügbaren Elektrizität verbessert wird.

Im Gegenteil zu herkömmlichen Wechselrichtern ist es möglich in Synchrongeneratoren durch Einstellung der Erregung Bindleistung zu speichern bzw. zu steuern.

Von Hause aus sind Synchrongeneratoren im Vergleich zu Wechselrichtern mit Leistungshalbleiterbauelementen robust gegen Kurzschlüsse und Überspannungen.

Diese großen Vorteile wurden von den bisherigen Planern und Entwicklern großer Fotovoltaik-Kraftwerke nicht erkannt. Der Blick war in der Vergangenheit und ist in der Gegenwart auf den Anschluss von Fotovoltaik-Kraftwerken durch Wechselrichter mit Leistungshalbleiterbauelementen verengt.

Bei einem erfindungsgemäßen Fotovoltaik-Kraftwerk kann wenigstens eine der Wellen mit einer Schwungmasse verbunden sein oder eine Schwungmasse kann von einer der Wellen antreibbar sein. Die Schwungmasse ermöglicht eine weitere Speicherung von kinetischer Energie, was das Fotovoltaik-Kaftwerk unabhängiger von kurzfristigen Schwankungen der Sonneneinstrahlung macht.

Die Schwungmasse kann in einer besonderen Ausführung der Erfindung über eine Kupplung mit einer der Wellen verbunden werden. Je nach Zustand der Kupplung kann Energie von der Welle auf die Schwungmasse oder Energie von der Schwungmasse auf die Welle übertragen werden oder die Energie bleibt in der Schwungmasse gespeichert. Ist die Kupplung eingekuppelt, wird Energie übertragen. Ist die Kupplung ausgekuppelt, findet kein Energietransport statt. Kinetische Energie kann dadurch bedarfsweise gespeichert oder in elektrische Energie gewandelt werden.

Ein erfindungsgemäßes Fotovoltaik-Kraftwerk kann neben dem ersten zentralen Umformer einen zweiten zentralen Umformer, nämlich einen Zentralwechselrichter, zum Wandeln des von den Fotovoltaik-Modulen erzeugbaren Gleichstroms in einen Wechselstrom aufweisen. Dieser Wechselstrom kann Ober- und Unterschwingungen enthalten. Der Elektromotor des ersten zentralen Umrichters ist dann vorteilhaft ein Asynchronmotor, der von dem Zentralwechselrichter mit elektrischer Energie versorgt wird. Der Zentralwechselrichter stellt einen Strom zur Verfügung, der bei der Erfindung nicht den Anforderungen eines Netzbetreibers zur Einspeisung genügen muss. Das ist aber unschädlich, da keine elektrische Kopplung zwischen dem Zentralwechselrichter und dem Versorgungsnetz besteht. Der Asynchronmotor ist so ausgelegt, dass er unbeschadet von Oberschwingungen und Unterschwingungen am Ausgang des Zentralwechselrichters betrieben werden kann. Besondere Filter sind dazu am Ausgang des Zentralwechselrichters nicht notwendig.

Ein erfindungsgemäßes Fotovoltaik-Kraftwerk kann neben dem ersten zentralen Umformer dezentrale Umformer, insbesondere Strangwechselrichter aufweisen, von denen je einer in einen Strang geschaltet ist, um den von den Fotovoltaik-Modulen eines Strangs erzeugbaren Gleichstrom in einen Wechselstrom zu wandeln. Auch bei einem solchen Fotovoltaik-Kraftwerk kann der wenigstens eine Elektromotor des ersten zentralen Umrichters ein Asynchronmotor sein. Auch die Strangwechselrichter stellen einen Strom zur Verfügung, der bei der Erfindung nicht den Anforderungen eines Netzbetreibers zur Einspeisung genügen muss. Besondere Filter sind daher am Ausgang des Fotovoltaik-Kraftwerks nicht notwendig, um zu einer netzkonformen Spannung zu kommen.

Es ist sogar möglich, dass der erste zentrale Umrichter mehrere Asynchronmotoren aufweist, deren Wellen miteinander verbunden sind. Jedem Asynchronmotor sind eine oder mehrere Stränge des Fotovoltaik-Kraftwerks zugeordnet und die Asynchronmotoren können durch diese Stränge mit elektrischer Energie versorgt werden. Wellen der Asynchronmotoren können starr miteinander verbunden sein. Es ist auch möglich, dass die Wellen über Kupplungen und/oder Getriebe, auch Schaltgetriebe, miteinander verbunden sind.

Der oder die verwendeten Asynchronmotoren können Mehrphasen-Asynchronmotoren, insbesondere Dreiphasen-Asynchronmotoren sein. Die Anzahl der Phasen kann der Anzahl der Stränge des Fotovoltaik-Kraftwerks entsprechen oder ein ganzzahliger Bruchteil der Anzahl der Stränge sein.

Ein Ständer des Asynchronmotors oder die Ständer der Synchronmotoren können mehr als ein Polpaar aufweisen. Die Anzahl der Polpaare kann der Anzahl der Stränge des Fotovoltaik-Kraftwerks oder einem ganzzahligen Bruchteil der Anzahl der Stränge entsprechen.

Zwischen dem ersten zentralen Umformer und dem Ausgang des Kraftwerkes kann ein Transformator geschaltet sein, um die vom ersten zentralen Umformer lieferbare Spannung auf die Spannung im Versorgungsnetz anzuheben. Solche Transformatoren, die die Spannungsform nicht wesentlich beeinflussen, sind zum Beispiel von Dampf- oder Kernkraftwerken bekannt.

Ein besonderer Vorteil eines erfindungsgemäßen Fotovoltaik-Kraftwerkes ist, dass die Stränge des Fotovoltaik-Kraftwerkes geographisch verteilt angeordnet sein können. Die zu den Strängen gehörenden Fotovoltaik-Module können mehrere Kilometer voneinander entfernt installiert sein und über Leitungen kann der von den Modulen erzeugte Strom ggf. unter Zwischenschaltung eines Wechselrichters zu dem ersten zentralen Umrichter geleitet werden, um in netzkonformen Strom gewandelt zu werden. Die geographische Verteilung der Module hat den Vorteil, dass das Fotovoltaik-Kraftwerk unabhängiger von den lokalen Bedingungen, insbesondere Wetterbedingungen an einem Ort ist. Dadurch ist die Leistung des Fotovoltaik-Kraftwerkes gleichmäßiger als bei einem Fotovoltaik-Kraftwerk, welches den Bedingungen nur eines Ortes ausgesetzt ist. Starke Leistungswechsel können vermieden werden, was dem Versorgungsnetzbetreiber die Einbindung des Fotovoltaikkraftwerkes in das Versorgungsnetz erleichtert.

Vorteilhaft hat ein erfindungsgemäßes Fotovoltaik-Kraftwerk eine Leistung von mehr als 100 kW, insbesondere von mehr als 1 MW. Dann können die Vorteile eines erfindungsgemäßen Fotovoltaikkraftwerkes besonders gut ausgespielt werden.

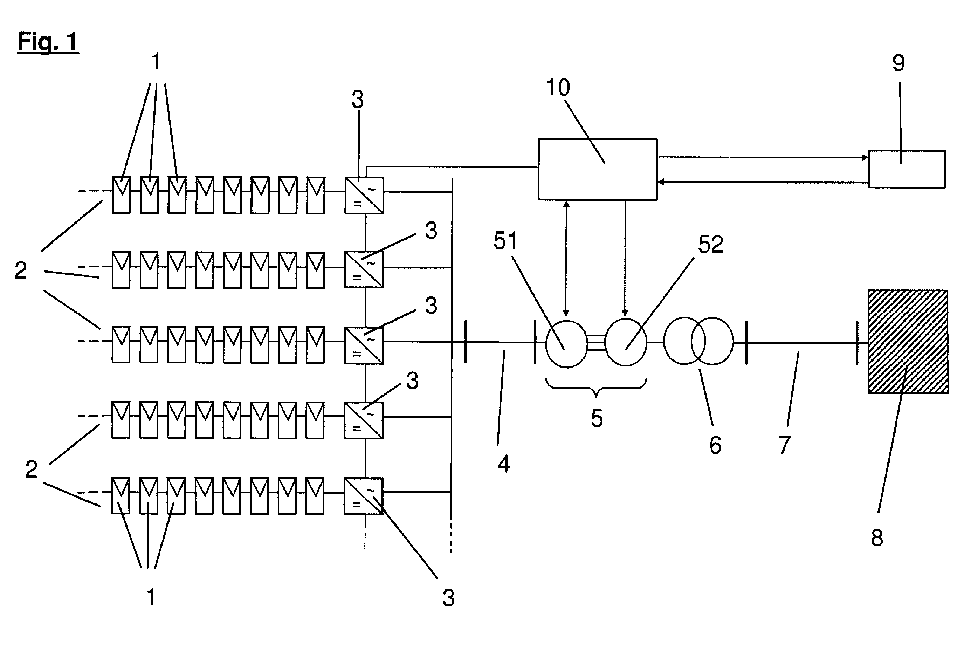

Ein Ausführungsbeispiel für ein erfindungsgemäßes Fotovoltaik-Kraftwerk ist anhand der Zeichnung näher beschrieben. Es zeigt
- Fig. 1: ein schematisches Schaltbild des Fotovoltaik-Kraftwerkes.

Das erfindungsgemäße Fotovoltaik-Kraftwerk weist eine Vielzahl von Fotovoltaikmodulen 1 auf, die in mehreren Strängen 2 in Reihe geschaltet sind. Die Stränge 2 sind an Strangwechselrichter 3 angeschlossen. An den Ausgängen der Strangwechselrichter 3 wird eine Spannung von 10 kV zur Verfügung gestellt. Die Ausgänge der Strangwechselrichter 3 sind über eine Mittelspannungsleitung 4 mit einem ersten zentralen Umrichter 5 des Fotovoltaik-Kraftwerks angeschlossen. Die Mittelspannungsleitung 4 kann mehrere Außenleiter umfassen.

Der erste zentrale Umrichter 5 weist eine Asynchronmaschine 51 auf, bei der es sich um einen mehrphasigen Asynchronmotor mit mehreren Polpaaren handeln kann. Die Anzahl der Phasen entspricht dabei vorzugsweise der Anzahl der Außenleiter der Mittelspannungsleitung 4. Die Anzahl der Polpaare der Asynchronmaschine multipliziert mit der Anzahl der Phasen kann im übrigen der Anzahl der Stränge 2 des Fotovoltaik-Kraftwerkes entsprechen.

Eine Welle des Asynchronmotors aus 51 ist fest mit einer Welle eines Synchrongenerators 52 verbunden. Der Synchrongenerator 52 ist ebenfalls Teil des ersten zentralen Umrichters 5. Der Asynchronmotor 51 treibt daher den Synchrongenerator 52 an und erzeugt Strom.

Dem Synchrongenerator 52 ist ein Transformator 6 nachgeschaltet, der die am Ausgang des Synchrongenerators 52 anliegende Spannung auf die Spannung eines Versorgungsnetzes, im vorliegenden Fall eines Übertragungsnetzes, hochtransformiert. Die Spannung in dem Übertragungsnetz beträgt beispielhaft 110 kV. Diese Sekundärseite des Transformators 6 ist über eine Hochspannungsleitung 7 mit der Spannung 110 kV mit dem Übertragungsnetz 8 verbunden. Das Ende der Hochspannungsleitung 7 markiert den Ausgang des Fotovoltaik-Kraftwerkes.

Das Fotovoltaik-Kraftwerk weist eine Steuerung oder eine Steuerwarte 10 auf, von welcher die Wechselrichter 3, der Asynchronmotor 51 und der Synchrongenerator 52 gesteuert werden können. Die Steuerwarte 10 ist mit einer Steuerwarte 9 eines Betreibers des Übertragungsnetzes 8 verbunden. Die Steuerwarte 10 teilt der Steuerwarte 9 des Übertragungsnetzbetreibers den Status und die Verfügbarkeit, d.h. auch die Leistungsreserven des Fotovoltaikkraftwerkes mit. Umgekehrt teilt die Steuerwarte 9 des Übertragungsnetzbetreibers der Steuerwarte 10 des Betreibers des Kraftwerkes die bereitzustellende Blindleistung Q und den einzustellenden Wirkleistungsfaktor cos ϕ mit.

Entsprechend den Vorgaben des Übertragungsnetzbetreibers steuert und regelt der Kraftwerksbetreiber von der Steuerwarte 10 das Fotovoltaik-Kraftwerk. Insbesondere wird der Schlupf des Asynchronmotors und der Polradwinkel δ und der Erregerstrom I_{E} gesteuert bzw. geregelt. Auch die Leistung der Wechselrichter 3 kann durch die Steuerwarte eingestellt werden.

Das Netz innerhalb des Fotovoltaik-Kraftwerkes ist von dem Übertragungsnetz 8 galvanisch und elektromagnetisch vollständig entkoppelt. Die einzige Verbindung zwischen den beiden Netzen besteht über die mechanisch miteinander gekoppelten Wellen der Asynchronmaschine 51 und des Synchrongenerators 52. Durch diese elektromagnetische Entkopplung ist eine Wirkung von Störungen, die innerhalb des Netzes des Fotovoltaik-Kraftwerkes auftreten oder auftreten können auf das Übertragungsnetz 8 im Grunde ausgeschlossen. Oberschwingungen und Unterschwingungen, die im Netz des Fotovoltaik-Kraftwerkes auftreten, werden nicht über den rotierenden Umformer 5 übertragen. Zudem hat das Kraftwerk durch den Umformer 5 den Vorteil, dass Leistungsschwankungen des Fotovoltaik-Kraftwerkes durch die Schwungmasse und Trägheit der rotierenden Teile des Umformers 5 sich nur abgeschwächt auf das Übertragungsnetz 8 auswirken. Durch die Möglichkeit einer geographischen Verteilung der verschiedenen Stränge 2 des Fotovoltaik-Kraftwerkes ist darüber hinaus eine weitere Vergleichmäßigung der Leistung des Fotovoltaik-Kraftwerkes möglich, da eine lokale Beschattung der Fotovoltaikmodule 1 eines Stranges 2 die Leistung des Fotovoltaik-Kraftwerkes nur zum Teil absenkt während bei anderen bekannten Fotovoltaikkraftwerkes eine lokale Beschattung zu einer sprunghaften Leistungsänderung des gesamten Kraftwerks führen kann.

## Patentansprüche

1. Fotovoltaik-Kraftwerk
- mit Fotovoltaikmodulen (1) zur Stromerzeugung, die zu mehreren Strängen (2) zusammengeschaltet sind,
- mit einem ersten zentralen Umformer (5) zur Wandlung von von den Fotovoltaikmodulen erzeugter elektrischer Energie in elektrische Energie mit einer Spannung, die eine Spannungsform hat, die einer Spannungsform einer Spannung in einem Versorgungsnetz entspricht, und
- mit einem Ausgang zur Einspeisung der gewandelten elektrischen Energie in das Versorgungsnetz,
**dadurch gekennzeichnet, dass**
- der erste zentrale Umformer (5) wenigstens einen Asynchronmotor (51) und einen Synchron-Generator (52) aufweist, deren Wellen miteinander gekoppelt sind,
- das Fotovoltaik-Kraftwerk
- entweder einen zweiten zentralen Umformer, nämlich einen Zentralwechselrichter, zum Wandeln des von den Fotovoltaik-Modulen (1) erzeugbaren Gleichstroms in einen Wechselstrom aufweist, mit dem der Asynchronmotor des ersten zentralen Umformers versorgbar ist,
- oder dezentrale Umformer (3), von denen je einer in einen der Stränge geschaltet ist, um den von den Fotovoltaik-Modulen (1) eines Strangs (2) erzeugbaren Gleichstrom in einen Wechselstrom zu wandeln mit dem der Asynchronmotor des ersten zentralen Umformers versorgbar ist.

2. Fotovoltaik-Kraftwerk nach Anspruch 1 , **dadurch gekennzeichnet, dass** wenigstens eine der Wellen mit einer Schwungmasse verbunden ist oder eine Schwungmasse von einer der Wellen antreibbar ist.

3. Fotovoltaik-Kraftwerk nach Anspruch 2, **dadurch gekennzeichnet, dass** die Schwungmasse über eine Kupplung mit einer der Wellen verbindbar ist und je nach Zustand der Kupplung Energie von der Welle auf die Schwungmasse oder Energie von der Schwungmasse auf die Welle übertragbar ist.

4. Fotovoltaik-Kraftwerk nach einem der Ansprüche 1 bis 3, **dadurch gekennzeichnet, dass** in dem Fall, dass das Fotovoltaikkraftwerk dezentrale Umformer (3) aufweist, der erste zentrale Umrichter (5) mehrere Asynchronmotoren (51) aufweist, deren Wellen miteinander verbunden sind.

5. Fotovoltaik-Kraftwerk nach Anspruch 4, **dadurch gekennzeichnet, dass** jedem Asynchronmotor (51) ein Strang des Fotovoltaik-Kraftwerks (2) zugeordnet ist oder mehrere Stränge (2) des Fotovoltaik-Kraftwerks zugeordnet sind und die Asynchronmotoren (51) durch diese Stränge (2) mit elektrischer Energie versorgbar sind.

6. Fotovoltaik-Kraftwerk nach einem der Ansprüche 1 bis 3, **dadurch gekennzeichnet, dass** der Asynchronmotor (51) ein Mehrphasen-Asynchronmotor, insbesondere ein Dreiphasen-Asynchronmotor ist.

7. Fotovoltaik-Kraftwerk nach Anspruch 6, **dadurch gekennzeichnet, dass** die Anzahl der Phasen der Anzahl der Stränge (2) des Fotovoltaik-Kraftwerks entspricht.

8. Fotovoltaik-Kraftwerk nach einem der Ansprüche 1 bis 5, **dadurch gekennzeichnet, dass** ein Ständer des Asynchronmotors (51) mehr als ein Polpaar aufweist.

9. Fotovoltaik-Kraftwerk nach Anspruch 8, **dadurch gekennzeichnet, dass** die Anzahl der Polpaare der Anzahl der Stränge (2) des Fotovoltaik-Kraftwerks entspricht.

10. Fotovoltaik-Kraftwerk nach einem der Ansprüche 1 bis 9, **dadurch gekennzeichnet, dass** zwischen dem ersten zentralen Umformer (5) und dem Ausgang des Fotovoltaikkraftwerkes ein Transformator (6) geschaltet ist, um die vom ersten zentralen Umformer (5) lieferbare Spannung auf die Spannung im Versorgungsnetz anzuheben.

## Claims

1. Photovoltaic power plant
- comprising photovoltaic modules (1) for power generation, which are connected to one another to form a plurality of strings (2),
- comprising a first central converter (5) for converting electrical energy generated by the photovoltaic modules into electrical energy with a voltage which has voltage waveform which corresponds to a voltage waveform of a voltage in a supply grid, and
- comprising an output for feeding the converted electrical energy into the supply grid,
**characterized in that**
- the first central converter (5) has at least one asynchronous motor (51) and a synchronous generator (52), the shafts of which are coupled to one another,
- the photovoltaic power plant
- either has a second central converter, namely a central inverter, for converting the direct current which can be generated by the photovoltaic modules (1) into an alternating current which can be used to supply the asynchronous motor of the first central converter,
- or has decentralized converters (3), of which in each case one is connected into one of the strings in order to convert the direct current which can be generated by the photovoltaic modules (1) in a string (2) into an alternating current which can be used to supply the asynchronous motor of the first central converter.

2. Photovoltaic power plant according to Claim 1, **characterized in that** at least one of the shafts is connected to a flywheel or a flywheel is driveable by one of the shafts.

3. Photovoltaic power plant according to Claim 2, **characterized in that** the flywheel is connectable to one of the shafts via a clutch and, depending on the state of the clutch, energy is transmittable from the shaft to the flywheel or energy is transmittable from the flywheel to the shaft.

4. Photovoltaic power plant according to one of Claims 1 to 3, **characterized in that**, in the event that the photovoltaic power plant has decentralized converters (3), the first central converter (5) has a plurality of asynchronous motors (51), whose shafts are connected to one another.

5. Photovoltaic power plant according to Claim 4, **characterized in that** a string of the photovoltaic power plant (2) is assigned to each asynchronous motor (51) or a plurality of strings (2) of the photovoltaic power plant are assigned to each asynchronous motor (51), and electrical energy can be supplied to the asynchronous motors (51) by these strings (2).

6. Photovoltaic power plant according to one of Claims 1 to 3, **characterized in that** the asynchronous motor (51) is a polyphase asynchronous motor, in particular a three-phase asynchronous motor.

7. Photovoltaic power plant according to Claim 6, **characterized in that** the number of phases corresponds to the number of strings (2) of the photovoltaic power plant.

8. Photovoltaic power plant according to one of Claims 1 to 5, **characterized in that** a stator of the asynchronous motor (51) has more than one pole pair.

9. Photovoltaic power plant according to Claim 8, **characterized in that** the number of pole pairs corresponds to the number of strings (2) of the photovoltaic power plant.

10. Photovoltaic power plant according to one of Claims 1 to 9, **characterized in that** a transformer (6) is connected between the first central converter (5) and the output of the photovoltaic power plant in order to increase the voltage which can be provided by the first central converter (5) to the voltage in the supply grid.

## Revendications

1. Centrale électrique photovoltaïque présentant
des modules photovoltaïques (1) qui produisent du courant et qui sont rassemblés en plusieurs lignes (2),
un premier convertisseur central (5) qui convertit l'énergie électrique produite par les modules photovoltaïques en une énergie électrique dont la tension présente une forme qui correspond à la forme de la tension d'un réseau d'alimentation et
une sortie qui injecte l'énergie électrique convertie dans le réseau d'alimentation,
**caractérisée en ce que**
le premier convertisseur central (5) présente au moins un moteur asynchrone (51) et un générateur synchrone (52) accouplés l'un à l'autre,
**en ce que** la centrale électrique photovoltaïque présente
un deuxième convertisseur central, à savoir un onduleur central, qui convertit le courant continu qui peut être produit par les modules photovoltaïques (1) en un courant alternatif qui permet d'alimenter le moteur asynchrone du premier convertisseur central ou
des convertisseurs décentralisés (3), chacun raccordé à l'une des lignes pour convertir le courant continu que peuvent produire les modules photovoltaïques (1) d'une ligne (2) en un courant alternatif qui permet d'alimenter le moteur asynchrone du premier convertisseur central.

2. Centrale électrique photovoltaïque selon la revendication 1, **caractérisée en ce qu'**au moins l'un des arbres est raccordé à une masse d'inertie ou **en ce qu'**une masse d'inertie peut être entraînée par l'un des arbres.

3. Centrale électrique photovoltaïque selon la revendication 2, **caractérisée en ce que** la masse d'inertie peut être raccordée à l'un des arbres par l'intermédiaire d'un embrayage et **en ce que** selon la position de l'embrayage, l'énergie de l'arbre peut être transmise sur la masse d'inertie ou l'énergie de la masse d'inertie à l'arbre.

4. Centrale électrique photovoltaïque selon l'une des revendications 1 à 3, **caractérisée en ce qu'**au cas où la centrale électrique photovoltaïque présente des convertisseurs décentralisés (3), le premier convertisseur central (5) présente plusieurs moteurs asynchrones (51) dont les arbres sont raccordés les uns aux autres.

5. Centrale électrique photovoltaïque selon la revendication 4, **caractérisée en ce qu'**une ligne de la centrale électrique photovoltaïque (2) est associée à chaque moteur asynchrone (51) ou **en ce que** plusieurs lignes (2) de la centrale électrique photovoltaïque sont associées à chaque moteur asynchrone, les moteurs asynchrones (51) pouvant être alimentés en énergie électrique par ces lignes (2).

6. Centrale électrique photovoltaïque selon l'une des revendications 1 à 3, **caractérisée en ce que** le moteur asynchrone (51) est un moteur asynchrone polyphasé et en particulier un moteur à asynchrone triphasé.

7. Centrale électrique photovoltaïque selon la revendication 6, **caractérisée en ce que** le nombre des phases correspond au nombre des lignes (2) de la centrale électrique photovoltaïque.

8. Centrale électrique photovoltaïque selon l'une des revendications 1 à 5, **caractérisée en ce qu'**un stator du moteur asynchrone (51) présente plus d'une paire de pôles.

9. Centrale électrique photovoltaïque selon la revendication 8, **caractérisée en ce que** le nombre des paires de pôles correspond au nombre des barreaux (2) de la centrale électrique photovoltaïque.

10. Centrale électrique photovoltaïque selon l'une des revendications 1 à 9, **caractérisée en ce qu'**un transformateur (6) est raccordé entre le premier convertisseur central (5) et la sortie de la centrale électrique photovoltaïque pour amener la tension que peut délivrer le premier convertisseur central (5) à la tension qui règne dans le réseau d'alimentation.
